(19)

Europäisches
Patentamt
European
Patent Office
Office européen
des brevets

(11) **EP 2 944 604 A1**

(12) **EUROPEAN PATENT APPLICATION**

(43) Date of publication:
**18.11.2015 Bulletin 2015/47**

(51) Int Cl.:
***B81C 1/00*** *(2006.01)*

(21) Application number: **14305725.5**

(22) Date of filing: **16.05.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
• **Université de Strasbourg**
**67000 Strasbourg (FR)**
• **Centre National de la Recherche Scientifique (CNRS)**
**75016 Paris (FR)**

(72) Inventors:
• **Decher, Gero**
**77694 Kehl (DE)**
• **Blell, Rebecca**
**67000 Strasbourg (FR)**

• **Hu, Hebing**
**67000 Strasbourg (FR)**
• **Pauly, Matthias**
**67200 Strasbourg (FR)**
• **Felix, Oliver**
**67810 Holtzheim (DE)**
• **Martel, David**
**67420 Saulxures (FR)**
• **Lin, Xiaofeng**
**67000 Strasbourg (FR)**
• **Sekar, Sribharani**
**67000 Strasbourg (FR)**
• **Seydina, Diabang**
**67000 Strasbourg (FR)**
• **Bayer, Jonas**
**65232 Taunusstein (DE)**

(74) Representative: **Regimbeau**
**20, rue de Chazelles**
**75847 Paris Cedex 17 (FR)**

(54) **Preparation of coatings containing at least one in-plane oriented layer of anisotropic shaped objects**

(57) The subject matter of the present invention concerns the preparation of a coated solid surface wherein the coating contains at least one in-plane oriented layer of anisotropic shaped objects through a specific spraying method, and the device enabling this method. The method includes the preparation of a solution, suspension or dispersion of interacting objects, and the spraying of the solution, suspension or dispersion on a solid surface with an angle preferably inferior to 30°, with respect to the plane formed by the solid surface to be coated, and a droplet speed superior to 0.1 meters per second.

sample

20 deg

FIGURE 5

EP 2 944 604 A1

## Description

The present invention relates to the preparation of in-plane oriented anisotropic objects thin layers through a spraying method.

INTRODUCTION

Oriented thin layers of organic and inorganic nanometric, or even micrometric, materials are used for several applications ranging from optical polarizers to optoelectronic devices.

These oriented thin layers (also called films) are often prepared by applying an external force (through e.g. magnetic, electric fields or mechanical means), by epitaxial growth, using soft or hard templates (see for instance Liu, Q.; Cui, Y.; Gardner, D.; Li, X.; He, S.; Smalyukh, I. I., Self-Alignment of Plasmonic Gold Nanorods in Reconfigurable Anisotropic Fluids for Tunable Bulk Metamaterial Applications. Nano Lett. 2010, 10, 1347-1353) or by self-assembly at a liquid-liquid or liquid-gas interface such as found in the Langmuir-Blodgett method (See e.g. Andrea Tao et al.; "Langmuir-Blodgett Silver Nanowire Monolayers for Molecular Sensing Using Surface-enhanced Raman Spectroscopy"; Nano Letters (2003), Vol. 3; No 9; 1229-1233 or Hong-Yan Shi et al.; "Ordering of Disordered Nanowires: Spontaneous Formation of highly Aligned, Ultralong Ag Nanowire Films at oil-water-air Interface"; Adv. Funct. Mater. (2010); 20; 958-964).

However, several drawbacks in the known art can be identified.

Although, the uses of electric and/or magnetic fields do enable to orient objects (see. e.g.: Shashank Shekhar et al.; "Ultrahigh Density Alignment of Carbon Nanotube Arrays by Dielectrophoresis"; ACS Nano (2011); Vol. 5; No. 3; 1739-1746; or Carlos M Hangarter et al.; "Hierarchical magnetic assembly of nanowires"; Nanotechnology (2007); 18; 205305 (7pp)), these techniques, however, do not enable to evenly orient on large surfaces said objects. This is in part due to the difficulties of providing even and parallel magnetic and/or electric fields over large areas.

Spin-coating is known to be used to orient objects in a near-parallel way with respect to the substrate (see e.g. Arnaud Dessombz et al.; "Evidence for Photoconductivity Anisotropy in aligned TiO2 nanorod Films"; J. Phys. Chem. C. (2010); 114; 19799-19802). However, as the orientation is radial, this prevents from any parallel orientation through-out the surface obtained, especially on large areas.

Other techniques have been reported, such as Stirring Assisted assembly of particles at liquid-solid interfaces (Wen-Ze Li et al.; "Stirring-assisted assembly of Nanowires at liquid-solid interfaces"; Nanotechnolgy (2013); 24; 105302 (6pp)) or through fluidic channel alignment (Yu Huang et al.; "Directed Assembly of One-dimensional Nanostructures into Functional Networks";

Science (2001); vol. 291; 630-633). Epitaxial growth is simply a transfer of the orientation of one layer to the next. It is therefore compulsory to have a pre-oriented layer from start-on (Lee, S. G.; Kim, H.; Choi, H. H.; Bong, H.; Park, Y. D.; Lee, W. H.; Cho, K., Evaporation-Induced Self-Alignment and Transfer of Semiconductor Nanowires by Wrinkled Elastomeric Templates. Adv. Mater. 2013, 25, 2162-2166).

However, these methods do not seem directly applicable to large surface areas. Therefore, most of the prior art technics can only be achieved on size-limited surfaces, mainly due to the lack of effectiveness and homogeneity of force fields on large areas. There are however a few exceptions in the known methods which are applicable to large surfaces: orientation by a shear force applied by a liquid flow or a mechanical force. However, these methods do have some drawbacks.

For instance, the mechanical shear force is limited to deformable surfaces and does not maintain the original form of the layer due to the tensions and compression forces applied (Pérez-Juste, J.; Rodríguez-González, B.; Mulvaney, P.; Liz-Marzán, L. M., Optical Control and Patterning of Gold-Nanorod-Poly(vinyl alcohol) Nanocomposite Films. Adv. Funct. Mater. 2005, 15, 1065-1071)

Flow induced alignment, as it is reported in WO2008/147431 amongst other ways to orient objects, lacks convenience because the deposit of the liquid containing the anisotropic objects and orientation of said objects is done in two distinct steps, and thus the objects will interact with the surface to be coated, before being oriented, possibly leading to the adsorption of misoriented objects.

More recently, in US 2014/0044865 (which is an equivalent patent application of article Ossama Assad et al.; "Spray coating Route for highly Aligned and Large-Scale Arrays of Nanowires"; ACS Nano (2012); Vol. 6; No. 6; 4702-4712) was described a method wherein the objects are sprayed on a heated surface and the solvent chosen vaporizes when the sprayed droplets touch said surface. The orientations of the objects obtained on the substrates in US 2014/0044865 are reported to be very good. However the method lacks flexibility as it is directly dependent on the vaporization of the solvent(s). This vaporization is reported to help the orientation of the sprayed objects. It is thus compulsory in the method of US 2014/0044865 to heat the substrate/solid surface to be coated or use particular volatile solvents - which are not always compatible with the objects to be deposited on the substrate. Moreover, the process described in US 2014/0044865 does not deal with the issue of interface relationships between the solid surface(s) to be coated and the oriented thin layer of objects or even the interfacial relationships embedded within the multilayer coatings themselves. Indeed, one of the issues encountered with coatings, especially when they are sprayed on large areas, are the interfacial relationships implied. For example, the capacity of thin layers to stay adsorbed uniformly on solid surfaces in the long term is a big concern as the coating can have a tendency to delaminate in an unwanted manner. Although, this depends as much on the nature of the surface as on the nature of the objects sprayed thereon, the process disclosed in US 2014/0044865 clearly lacks flexibility to provide means of solution(s) of such a problem, by e.g. adding an interfacial component which will ensure the cohesion of the thin layer of oriented objects to the solid surface supporting it, or will directly enforce the cohesion of the thin layer itself. The process described in US 2014/0044865 does not deal with these technical issues.

Therefore, there is still a strong need for a process which enable obtaining oriented layers with a controlled architecture (composition, density, orientation and interlayer spacing), which is easily workable and thus flexible (i.e. not implicating particular solvents which might not be compatible with sprayed objects), which is easily applicable on large areas and which thus efficiently deals with interface issues on the substrate/solid surface and within the coating.

The present invention, although somewhat similar to the technology reported in US 2014/0044865, actually implicates a totally different technical effect which has been undisclosed until now, and necessitates particular spraying conditions. This particular effect enables to envisage a much larger spectrum of applications than previously. The inventors of the present invention have indeed surprisingly noticed that by creating a continuous liquid moving thin layer on the surface of the solid surface to be coated using spraying methods, it is possible to orient in a controlled manner the sprayed objects.

By creating this continuous liquid thin layer in the process, it is possible to increase the flexibility of the technique to all types of solvents and thus to all types of substrates, whilst adding the convenient chemical species enabling better interface interactions, and thus to easily adapt the process to large areas of substrate to be coated and/or to the desired thickness and number of thin layers in the coating.

SUMMARY OF THE INVENTION

The present invention concerns a process of preparation, preferably at ambient or low temperature, of a coated solid surface wherein the coating contains at least one in-plane oriented layer of anisotropic shaped objects, preferably presenting at least one dimension of the nanometric or micrometric order, comprising:

a) the preparation of at least one solution, suspension or dispersion of interacting objects,
b) the spraying of at least one solution, suspension or dispersion of step a) on a solid surface said spraying is done with :

- an angle inferior to 80°, preferably inferior to 30°, with respect to the plane formed by the solid surface to be coated,

- a droplet speed superior to 0.1 meters per second, preferably superior to 0.5 meters per second,

c) previously, simultaneously or subsequently to step b), an optional spraying or application of at least one complementary interacting chemical species, such as an interface and/or cohesion agent, onto the coated and/or uncoated surface,

- steps a), b) and/or c) being reproduced as many times as necessary to obtain the desired coating, and

d) retrieving the coated solid surface.

Therefore, one aspect of the present invention concerns a coating obtainable by the process presently disclosed, characterized in that the nematic order parameter of said coating is comprised between 0.5 and 1, preferably between 0.75 to 1, more preferably between 0.90 to 1, and even more preferably between 0.95 and 1. Advantageously, at least 80% of the anisotropic shaped objects have an orientation angle distribution comprised in the range of + or - 20°, preferably + or - 10°, more preferably + or - 5°, with respect to the mean orientation of said anisotropic shaped objects. Preferably, at least 85% of the anisotropic shaped objects have an orientation angle distribution comprised in the range of + or - 20°, preferably + or - 10°, more preferably + or - 5°, with respect to the mean orientation of said anisotropic shaped objects. More preferably, at least 90% of the anisotropic shaped objects have an orientation angle distribution comprised in the range of + or - 20°, preferably + or - 10°, more preferably + or - 5°, with respect to the mean orientation of said anisotropic shaped objects.

Another aspect of the present invention concerns a coating comprising one in-plane oriented layer of anisotropic shaped objects characterized in that the nematic order parameter of said coating is comprised between 0.5 and 1, preferably between 0.75 to 1, more preferably between 0.90 to 1, and even more preferably between 0.95 and 1, and optionally at least one complementary interacting chemical species such as an interface and/or cohesion agent. Advantageously, at least 80% of the anisotropic shaped objects have an orientation angle distribution comprised in the range of + or - 20°, preferably + or - 10°, more preferably + or - 5°, with respect to the mean orientation of said anisotropic shaped objects. Preferably, at least 85% of the anisotropic shaped objects have an orientation angle distribution comprised in the range of + or - 20°, preferably + or - 10°, more preferably + or - 5°, with respect to the mean orientation of said anisotropic shaped objects. More preferably, at least 90% of the anisotropic shaped objects have an orientation angle distribution comprised in the range of + or - 20°, preferably + or - 10°, more preferably + or - 5°, with respect to the mean orientation of said anisotropic shaped objects.

Yet another aspect of the present invention concerns the use of a coating according to the present invention for optical means, such as an optical polarizer, optical waveguide, a television screen, 3D screens, transparent conductive layer, chemical or biological detector (for example SERS substrate), electro/magnetic means, such as an electronic device, in particular nanowire-based field effect transistor, conductivity controlled device, magnetic device (for example for magnetic data recording), magnetoresistive device or an anisotropic device, or mechanical means such as a composite material with high Young's modulus (e.g. to a value equal or superior to 0.5 GigaPascal(GP), equal or superior to 1 GP, equal or superior to 5GP, equal or superior to 10GP, equal or superior to 20GP), which is a mechanically anisotropic film, or even oriented surfaces for biological cell culture.

The present invention also concerns a device for a spraying process in order to obtain a coating comprising at least one in-plane oriented layer of anisotropic shaped objects characterized in that said device comprises:

- at least one means of fixing a substrate, i.e. solid surface, to be coated on a support, said support being optionally arranged to allow the possibility of an angular orientation adjustment (i.e. adjustable or not, and preferably with a grazing incidence with respect to the solid surface to be coated);
- at least one spray holder, comprising at least one spray nozzle mounted in a fixed or movable way through at least a translation movement back and forth along the orthogonal direction of the spraying.

The present invention enables the use of a device as presently disclosed to prepare a large surface coating, preferably superior to 1 cm$^2$, more preferably superior to 10cm$^2$, even more preferably superior to 50cm$^2$, yet more preferably superior to 1m$^2$ or even 10m$^2$.

DEFINITIONS

Coating, multilayer coating

A "coating" is a covering which is applied to the surface of a macroscopic object, which can be referred to as a "substrate" or "solid surface". "Substrate" and "solid surface", in the boundaries of the present invention, are equivalent terms. In the present invention, the coating may entirely or partially cover the substrate. There is no restriction on the purpose of the coating in the present invention: said coating can be technically functional and/or decorative.

The coating can consist of one thin layer comprising oriented objects according to the present invention. The coating can also comprise several thin layers, of which at least one comprises oriented objects according to the present invention, and is then referred to as a "multilayer coating". The term "coating" in the context of the present invention is thus a generic term which embraces monolayer or multilayer coatings.

There is no limit on the thickness of the coating, and coatings of some nanometers to several centimeters can be obtained in the context of the present invention.

For example it is possible according to the present invention to combine positive layers and negative polymer layers in an alternate way in order to increase the thickness of the coating. In the same way it is possible to insert between two layers a film with particular physicchemical properties, e.g. metallic, organic, biologic, etc.

Thin layer, film

The expression "thin layer" and the term "film" are equivalent in the context of the present invention. A "film" (and thus a thin layer) is well known to the person skilled in the art and refers to a coating on any solid surface. The thickness of the coating can be comprised between around one nanometer and several hundred micrometers. Advantageously, the method according to the invention permits obtaining a film with a thickness of 10 nm to 500 $\mu$m, advantageously between 0.1 $\mu$m and 100 $\mu$m.

Liquid film

The expression "liquid film" is well known to the person skilled in the art and refers to a liquid coating on any surface, in particular any solid surface in the context of the present invention. The thickness of the coating can be comprised between around ten nanometers and several millimeters. Advantageously, the method according to the invention permits obtaining a liquid film with a thickness of 50 nm to 1 mm, advantageously between 0.1 $\mu$m and 300 $\mu$m.

In-plane oriented or aligned layer

In the context of the present invention, the terms "oriented" and "aligned" are equivalent. Moreover, the "in-plane oriented layer" of objects is equivalent in meaning to a 2D array of objects, although the thickness of the array (i.e. thin layer) can be comprised between around one nanometers and several hundred micrometers, this dimension is in first view negligible with regards to the length and wideness of the film. It is thus, strictly speaking, a misuse of language to refer to a "2D array". In contrast, in the context of the present invention a 3D array would refer to an in-plane oriented layer, wherein the thickness is visible to the naked eye (i.e. in the order of 0.1 mm), and/or to several thin layers piled up one upon each other in a multilayer coating, with no restrictions on the total thickness of the 3D array.

The term "oriented", means that the objects (i.e.

anisotropic objects) comprised in the thin layer are arranged in an ordered way, i.e. that at least one of the same distinguishable dimensions of the objects is facing the same side of the coated substrate. Strictly speaking the term" aligned" means that the objects are lined up in the same direction. However, this term is commonly retrieved in the art with the meaning of "oriented" as defined presently. Therefore in the context of the present invention, "aligned" and "oriented" have the same meaning and can be used in an equivalent way. The orientation is said to be "in-plane", i.e. that one of the dimensions of the sprayed objects is parallel to the coated solid surface, preferably it is the larger distinguishable dimension of said objects which is parallel to the coated solid surface. The term "orientation" refers to in fact the mean orientation of the objects in the layer.

Anisotropic and Anisotropically shaped objects

In the context of the present invention, "anisotropically shaped objects" or "anisotropic objects" are equivalent.

The objects are shaped so that at least one of the dimensions is substantially bigger than the other ones, thus enabling to distinguish at least one repeated dimension from one object to the other. For example, in the case of cellulosic microfibrils, the diameter of the microfibrils will be substantially the same from one microfibril to the other, and the length of the microfibrils can substantially vary.

Advantageously the in-plane oriented layer presents anisotropic physical properties, i.e. which will interact with light in a particular way (such as surface plasmons resonance, effect on light polarization, etc.), and/or present varying mechanical properties depending on the orientation of the tension submitted (Young's modulus), and/or even present particular electronic transport properties depending on the orientation of the submitted electrical charge.

Moreover, it is of course well acknowledged in the art what is and what is not such an object - i.e. anisotropic nano- or micro-objects. In particular in the context of the present invention, such objects (organic or inorganic) are not "simple" molecular structures, but preferably macromolecules (e.g. equal or superior to 1000 D, advantageously equal or superior to 10000, more advantageously equal or superior to 50000 D, even more advantageously equal or superior to 100000 D). Advantageously, the term "anisotropic objects" includes inorganic or organic objects wherein the larger dimension is superior to 2nm and/or have an aspect ratio (i.e. ratio between the largest dimension and the smallest dimension) superior to 2, preferably superior to 5, 10, 20, 50, 100 or 1000. Preferably the larger dimension of the anisotropic objects according to the present invention is superior to 5nm, 10nm, 20nm or 50 nm. Assemblies of smaller molecules which once combined (by whatever interaction, such as weak bonds, Pi stacking, etc.) form an elongated assembly are in the context of the present invention covered by the definition "anisotropic objects".

The technical effect is such as the flow of liquid which enables a controlled organization of the anisotropic objects: the flow of liquid thus has a direct impact on the orientation of the sprayed objects.

For example, according to an embodiment, the anisotropic objects can be biological anisotropic objects, i.e. biological anisotropic objects (as defined hereunder, such as DNA) which can be deposited and oriented using the process of the present invention.

Indeed, certain anisotropic objects can function as templates or scaffolds, on which for example living cells can subsequently be deposited and/or grow in an ordered desirable way. In a particular embodiment, the anisotropic objects which function as such templates or scaffolds are biological anisotropic objects.

Therefore according to this specific embodiment, suitable biological anisotropic objects include, but are not limited to, elongated-shaped viruses, phages and peptide fibers, filamentous proteins, carbohydrate polymers (i.e. polysaccharides), DNA, RNA and other nucleoside fibers and molecules. These templates can self-assemble into long strands of tens of microns in length.

For the purpose of the present invention, the biological anisotropic objects can be hybrid molecules presenting a moiety which will easily interact with the substrate and a moiety consisting of a biological anisotropic object. For example, the object deposited on the solid surface can be rich in peptides, carbohydrate polymers or DNA.

In certain embodiments, multifunctional biomolecules such as polypeptides can be used as complementary interacting chemical species. Indeed, many substrates, including glass, polyester substrates (e.g., polyethylene terephthalate) exhibit affinities for polypeptides. Therefore, polypeptides can also be co-deposited on the substrate with the anistropic objects dispersion.

Polypeptide refers to a polymeric sequence of amino acids (monomers) joined by peptide (amide) bonds. The amino acid monomers in a polypeptide can be the same or different. Amino acids having side chain functionalities (e.g., amino or carboxylic acid groups) are preferred. Examples of suitable polypeptides thus include poly-L-lysine, poly-L-glutamic acid and the like.

Solution, suspension or dispersion of interacting objects

The interacting objects (i.e. anisotropic objects, preferably nano-objects) commonly are insoluble in the liquid which carries them.

The liquid can comprise several types of liquid chemicals.

Sometimes however, the interacting objects are found in solution, i.e. the whole entity comprising the objects and the liquid vehicle is homogeneous and the objects are directly in contact with the liquid vehicle. In this case the liquid vehicle which carries the objects is referred to as a "solvent". The liquid which in this case comprises the object and the solvent is referred to as a "solution".

In the other cases the liquid which carries the object will be referred to as "liquid vehicle".

The entity which comprises the liquid vehicle and objects, wherein said entity is inhomogeneous, is referred to as a "suspension" or "dispersion". A suspension distinguishes itself from a dispersion (or a solution) in that the objects are in the solid form and found regularly throughout the solid-in-liquid entity called "suspension". The dispersion, in the context of the present invention, will mainly refer to emulsions, i.e. a mixture of at least two liquids which are not miscible one with each other, dispersed one in the other in the form of regular (e.g. microscopic) droplets. At least one of the liquids carries the objects.

The ways of obtaining the solutions, dispersion or suspension of objects is not the subject-matter of the present invention, the present invention being applicable to all three types of entities, so long they can be sprayed.

The methods are thus commonly those disclosed in the art (Lu, A.-H.; Salabas, E. L.; Schüth, F., Magnetic Nanoparticles: Synthesis, Protection, Functionalization, and Application. Angew. Chem. Int. Ed. 2007, 46, 1222-1244, Daniel, M.-C.; Astruc, D., Gold Nanoparticles: Assembly, Supramolecular Chemistry, Quantum-Size-Related Properties, and Applications toward Biology, Catalysis, and Nanotechnology. Chem. Rev. 2003, 104, 293-346), for instance by promoting electrostatic or steric repulsions between neighbouring particles through functionalization with polymers, surfactants, ligands, proteins, DNA, ...

Interacting objects

In the context of the present application, the "objects" are the entities which present at least one repeated distinguishable dimension, also commonly referred to in the art as "nano-objects", i.e. objects presenting at least one homogenous dimension ranging between one nanometer and several hundred nanometers, or even several thousand nanometers.

For example, an embodiment of the process of the present invention is characterized in that the objects are nano-objects preferably chosen in the list consisting of nanowires, nanorods, nanobelts, nanoribbons, nanorice, nanotubes, nanofibers, microfibrils, and/or microfibers.

In the context of the present invention, the objects are "interacting", i.e. enabling at least an interaction with the solid surface (substrate) to be coated and/or chemical species comprised in the sprayed solution, suspension or suspension. All types of chemical/physico-chemical interactions known in the art can be used. For example, the interaction can be a straightforward chemical reaction (e.g. a nucleophilic coupling reaction), a complexing reaction, hydrogen bonding, acid-base or electrostatic interaction such as in the case of a salt formation, or even Van-der-Walls interactions. Moreover, it is possible to induce a reaction by an additional manipulation which may consist of the use of laser technology, or even the use of strong magnetic and/or electrical fields, the piezoelectric effect, thermal radiation, ultrasound, the application of an electrospray, electrochemistry, electromagnetic radiation such as microwave radiation, infrared radiation, UV radiation, etc., for example.

Thus, according to the method of the present invention, the interactions are advantageously controlled by determination of at least one of the following adjustment parameters:

- concentration of the objects or complementary interacting chemical species such as the interface and/or cohesion chemical agents and viscosity of the spraying liquid(s) containing said objects or complementary interacting chemical species such as the interface and/or cohesion chemical agents;
- composition and nature of the solvent present in each of the liquids sprayed;
- temperature of the sprayed liquids;
- dimension, density, speed and polydispersity of the droplets according to the geometry and nature of the spray nozzles;
- variation of the angles at the top of the spray jet dispersion cones;
- distance between the nozzles and the surface on which the liquid thin layer forms;
- incline of said surface with regard to the main axis of the spray jets;
- spray jet flow rate for the various liquids;
- nature, temperature, flow rate and/or pressure of the carrier gas used for spraying;
- nature of the substrate.

These characteristics are well known to the person skilled in the art who knows how to adjust them individually with regard to the other characteristics and according to the desired properties of the film in which the reactions occur.

Ambient temperature

In the context of the present invention, "ambient temperature" means temperature found from 10°C to 40°C, preferably from 15°C to 30°C, more preferably from 20°C to 25°C, with respect of the freezing point of water at sea level at atmospheric pressure.

Low temperature

In the context of the present invention, "low temperature" means temperature under 40°C, preferably under 30°C, more preferably under 25°C, yet even more preferably under 20°C or temperatures under 10°C, 5°C, 0°C, -10°C or -20°C with respect of the freezing point of water at sea level at atmospheric pressure.

Solid surface/ substrate

In the context of the present invention, a "solid surface" and a "substrate" are equivalent terms as explained above. These terms both mean the surface of a macroscopic (i.e. with at least one dimension superior to 0.1 mm) solid entity, firm and rigid enough to support the spray jet(s) that is applied to it without deformation of the surface sprayed, which would impede the realization of the invention.

Spray

The word "spray" according to this invention concerns the production of a cloud of droplets, i.e., containing micro or nanoscale droplets, liquids and/or solids, suspended in the gas containing them and which optionally carries them or the space that contains them. This moving cloud of droplets will be defined as a spray jet or "spray". This spray jet can have any form (solid cone, hollow cone (particles are only present at the periphery of the cone, for example), linear, etc.). The spray is obtained by a sprayer, which can be an atomizer or any other device well known to the person skilled in the art. Advantageously, this sprayer consists of at least one nozzle for liquid outlet that allows suspending said liquid in the form of droplets in a carrier gas or in the atmosphere (environmental gas). Any type of nozzle that permits spraying is usable. The word "nozzle" therefore refers to the device producing a droplet cloud.

Spraying

Generally speaking, spraying is used for different industrial applications: automobile industry, food processing industry, chemical industry, paper industry, electronics industry, etc.

Spraying is a complex method that is found in industry and in nature. It is the subject of numerous scientific publications and patents. This important field of engineering has incited theoreticians to develop models to describe the phenomenon of spraying and engineers to conduct different studies (change of key parameters for spraying: shape/diameter of the nozzle, liquid-gas mixing, adaptation of the spraying for a precise application, characterisation of jets according to several methods, finding other fields of application for spraying).

Thus, different types of spraying exist: spray-aerosols that make it possible to vaporise a liquid by the pressurised gas that is in the aerosol, sprayings delivered by a carrier gas (it is necessary to distinguish the surrounding gas playing a passive role for example for single compound nozzles and the carrier gas playing an active role for nozzles with 2 compounds or more) with different pressures (low, medium, high). Moreover, the liquid-gas mixing can take place in different ways as a function of the geometry of the nozzle, by generation of a spray by a turning device, by electrostatic spraying, by ultrasonic spraying, etc. The implementation techniques of all these nozzles are well known to those skilled in the art. For example, the presence of gas is not mandatory in certain specific cases. Nevertheless, in a more usual manner the invention takes place at atmospheric pressure. All types of spraying are applicable to the present invention method, as long as they are tuned in order to produce a continuous moving thin layer on the solid surface to be coated.

Spraying methods have for example already been used to produce multilayers of polyelectrolytes. It is much faster than the soaking method in the case of nanometric thin layers of polyelectrolytes. The construction of multilayers by alternate or simultaneous spraying is already known (see WO 99/35520, WO 2011/144748, WO2011/144754 and US 6,451,871, Schlenoff J. B., Dubas S. T., Farhat T. Sprayed polyelectrolyte multilayers. Langmuir 2000, 16, 9968-9969). These reported methods can easily be adapted to the present invention to incorporate for example polyelectrolytes in the coating (single or multilayer).

The subject of the invention can involve simultaneously spraying at least two clouds of droplets of micrometric or nanometric size each containing one either one of objects or complementary interacting chemical species, such as interface and/or cohesion chemical agents or a mixture thereof, through nozzles convergent in the direction of the solid surface on which is formed, by overlay of sprayed liquid jets, a homogenous moving thin layer in the form of a film of controlled thickness comprised between 0.1 $\mu$m and 100 $\mu$m inside of which the interaction with the solid surface mainly occurs leading to the in-plane oriented layer of anisotropic shaped objects.

Droplet velocity

The droplets speed, in the context of the present invention, is the measurable speed of the droplets at the closest distance of the solid surface to be coated before impact of the droplets on the surface or liquid thin layer. Preferably, this distance is between 0.5 cm and 100 cm, more advantageously between 0.5 cm and 20 cm and even more preferably between 1 and 10 cm from the surface to be coated. This distance is defined as the distance between the outer center of the nozzle and the arrival point of the center of the spray jet on the surface, measured in the direction of the center of spray jet.

The droplets, when impacting the previously formed liquid thin layer, will induce a movement of said thin layer, which means that all types of spraying is applicable to the present invention process. From a practical point of view, it is the combination of the droplet and gas in movement, i.e. corresponding to the whole of the spray cloud, which will generate the movement of the newly formed thin layer on the surface of the substrate to be coated.

The droplet speed is determined in meters/second (m/s) and can be adjusted accordingly to the products/liquids sprayed and/or substrate to be coated. According to the present invention, the droplet speeds can be superior or equal to 0.1 m/s, 0.2 m/s, 0.3 m/s, 0.4 m/s, 0.5 m/s, 0.6 m/s, 0.7 m/s, 0.8 m/s, 0.9 m/s, 1 m/s, 2 m/s, 3 m/s, 4 m/s, 5 m/s, 6 m/s, 7 m/s, 8 m/s, 9 m/s, 10 m/s, 15 m/s, 20 m/s, 25 m/s, 30 m/s, 35 m/s, 40 m/s, 45 m/s, 50 m/s, 100 m/s, 200 m/s, 300 m/s and/or comprised within the range of two of these values, e.g. comprised between 5 and 50 m/s, preferably between 10 and 25 m/s.

The spray speed can be determined by any means known in the art such as through the use of an optical array probe droplet analyzer.

Application (of an additional coating or layer)

In the context of the present invention, the term "application", i.e. "application of a coating", means all known methods for the skilled person in the art to deposit a coating or layer (such as a thin layer) on the substrate, which has previously or not been coated. These methods comprise soaking, poring, brushing, spraying and equivalent methods well known in the art.

Complementary interacting chemical species

Complementary interacting species are two or more chemical compounds that can be used to prepare so-called "layer-by-layer assembled films" which are widely known and investigated. In the context of the present invention, the expression "complementary interacting chemical species" also includes any chemical compound which can interact with the sprayed anisotropic objects, preferably in order to enhance the adhesion and/or cohesion of the oriented thin layer. Preferably the complementary interacting chemical species are chemical compounds capable of interacting with each other by interactions as defined above in the paragraph on "interaction objects", they are typically polyelectrolytes or nanoparticles.

Interface and/or cohesion chemical agent

In the context of the present invention the interface chemical agent is any chemical product which will act on the physico-chemical property of the surface of a layer. Preferably the interface chemical agent enables to enhance the interactions between layers and/or substrate enabling to assure cohesion and strength in regards to tension, compression, oxidation, hydration, etc. of the layers one with each other and/or the substrate.

In the context of the present invention the interface chemical agent is any chemical product which will interact within the layer to ensure the cohesion and strength in regards to tension, compression, oxidation, hydration, etc. of the layer *per se*. Advantageously, the interface chemical agent will also act as a cohesion chemical agent, and vice versa.

Nematic order parameter

In the context of the present application and in the art, the nematic order parameter (S) is used to quantify the degree of orientation:

$$S = (3\cos^2\theta - 1)/2$$

wherein $\theta$ is the angle between each nanoparticle and the main direction of orientation. The variable (S) is directly related with the range of distribution of angles, such that S = 0 for a group of completely disordered objects, and S = 1 for perfectly aligned objects.

DETAILED DESCRIPTION

The various technical criteria considered (reaction partners, spraying, etc.) are naturally applicable for all possible combinations.

A particular embodiment of the present invention concerns a process as disclosed therein, characterized in that the solution, suspension or dispersion of step a) comprises at least one non-volatile solvent or non-volatile liquid vehicle.

By "non volatile solvent or liquid vehicle", it is meant in the context of the invention that the solvent(s) or liquid vehicle(s) used in the process do not spontaneously vaporize once they touch the substrate.

Therefore, in an advantageous embodiment, the process of the present invention is characterized in that the boiling point(s) of the solvent(s) or vehicle liquid(s) present in the sprayed solution, suspension or dispersion are substantially above the temperature of the substrate, i.e. solid surface, to avoid evaporation of said solvent.

However, so long the boiling temperature of the solvent(s) or liquid vehicle(s) is not attained, the different elements used in the process, such as gas, solvents, vehicle, substrate, etc. can be heated, in particular to catalyze reactions.

In another embodiment, advantageously, the process of the present invention is characterized in that the spraying angle is below 30°, preferably below 20°, with respect to the plane formed by the surface of the substrate to be coated, i.e. the solid surface to be coated.

In one embodiment, advantageously, the process of the present invention is characterized in that the solid surface to be coated is essentially horizontal. In another embodiment, the process of the present invention is characterized in that the solid surface to be coated is tilted of whatever angle, e.g. below or equal to 90°, below or equal to 80°, below or equal to 70°, below or equal to 60°, below or equal to 50°, below or equal to 40°, below or equal to 30°, below or equal to 20°, below or equal to 10°, below or equal to 5° with respect to the horizontal, and the spraying can either be done in whatever angle with respect to the slope of the solid surface to be coated. For example, it is possible to spray the liquid upwards onto the solid surface to be coated and have a sufficient speed of spraying (i.e. tuned by the gas flow and/or liquid flow from the nozzle(s)) to counteract the gravity force. In a particular preferred embodiment of the present invention, the spraying onto the substrate is done with a grazing incidence, i.e. with an angle equal or inferior to 15° in regards to the surface to be coated, preferably equal or inferior to 10° in regards to the surface to be coated, more preferably equal or inferior to 5° in regards to the surface to be coated.

In a preferred embodiment, the process of the present invention is characterized in that said process comprises an extra step e) of rinsing, preferably after step a), b) and/or c). The rinsing can be done with all types of liquids and solvents used in the art.

These liquids/solvents can be applied by whatever means known in the art to the (coated) substrate.

More preferably, the process of the present invention is characterized in that the liquid used for rinsing is the same as at least one of the solvent(s) and/or vehicle liquid(s) present in the sprayed solution, suspension or dispersion.

These solvent(s) and/or vehicle liquid(s) can be polar or non-polar, organic or mineral, such as Water (MilliQ 18 M$\Omega$.cm), ethanol, methanol, propanol, pyridine, xylene, isopropanol, butanol, acetone, dimethyl formamide, dimethyl sulfoxide, acetonitrile, ethyl acetate, dicholoromethane, dichloroethane, diethylene glycol, chloroform, chlorobenzene, carbon tetrachloride, tetrahydrofuran, toluene, methyl pyrrolidinone, diethyl ether, cyclohexane, hexane, cyclopentane, and/or pentane. The solvents may contain a certain concentration (0-3 mol/L) of ions, including $Na^+$, $Cs^+$, $Li^+$, $K^+$, $NH_4^+$, $Be^{2+}$, $Mg^{2+}$, $Ca^{2+}$, $M^{2+}$, $Sr^{2+}$, $Ba^{2+}$ $Cl^-$, $Br^-$, $F^-$, $I^-$, $SO_4^{2-}$ $NO_3^-$, $PO_4^{3-}$.

In particular, in a preferred embodiment of the present invention, the quality of the water can be of any purity grade, preferably purified such as filtered, boiled, distilled, demineralized, or deionized water. The water can be slightly acidic or basic, preferably in a range of pH comprised between 4 and 10, more preferably between 5 and 9, even more preferably between 6 and 8, and in particular around pH 7.

One of the advantages of the process of the present invention is that it can be adapted to all kinds of facilities and premises ranging in scale from the laboratory (scale) to high throughput industry (scale), with the same quality of coatings achieved. The process of the present invention is thus foreseen as a highly adaptable and easy to establish process, enabling to fit to the particular technology of each wanted coating whilst also easily fitting to the premises. In this perspective, the only limit is set by the type of spraying nozzle with respect to its flow rate. For example, the process of the present invention is characterized in that the spraying of the solution or suspension of interacting objects is done within a range of liquid flow rate comprised between 0.001 mL to 10 L per minute per spray nozzle, preferably comprised between 0.01 mL to 1 L per minute per spray nozzle, for example comprised between 0.1 mL to 100 mL per minute per spray nozzle, or comprised between 0.2 mL to 10 mL per minute per spray nozzle, such as comprised between 0.5 mL to 5 mL per minute per spray nozzle.

In the context of the present invention, simultaneous spraying can be operated, i.e. the nozzles will spray different solutions, suspensions or dispersions. Advantageously the simultaneous spraying is done in a way that the sprays are convergent on the solid surface to be coated.

It is possible in the method according to the invention, in particular in addition to said simultaneous spray (or not), to conduct an additional spray of a gas and/or additional dilution solvent and/or other liquid containing other products such as, for example, surfactants or catalysts.

Means for controlling the spray

∘ Shape of the spray jet(s)

The spray jet(s) can have diverse and varied forms, for example solid or hollow cones, tighter or looser, according to the techniques for controlling sprays well known to the person skilled in the art.

Advantageously, according to the method of the invention, the spray nozzle(s) used generate cone shaped spray jet(s).

∘ Positioning of a movable shutter

In the method according to the invention, the spray can be controlled by interposing a screen with an opening calibrated to select the central part of the spray jet(s) and prevent contamination of the surface by the edges of the jet(s). The screen can be made of any type of material and in any possible form.

It may therefore be advantageous during spraying according to the method of the invention to interpose an additional screen between the nozzle(s) and the substrate with at least one opening passing alternatingly in front of the spray jet(s) to control the collisions and interactions of the sprayed droplets with determined areas of the solid surface to be coated.

The screen can be interposed between the nozzle(s) and substrate by any movement whatever.

Advantageously, the additional screen is interposed between the nozzle(s) and the substrate by a rotating movement. The screen is therefore called rotary in this particular embodiment.

Advantageously, the additional screen is interposed between the nozzle(s) and the substrate by a lateral linear movement on a system of runners, for example. The screen is therefore called linear in this particular embodiment.

It may also be advantageous during spraying according to the method of the invention to interpose an additional screen between the nozzle(s) and the substrate.

∘ Positioning of the spray jets

Advantageously, the spray devices (nozzle, sprayer, atomizer, etc.) are positioned so that the surface on which the solid surface to be coated is covered as best as possible, i.e., there are no "free" areas, which is to say areas not covered with the sprayed liquid.

Of course, it is possible, although this is not the preferred embodiment of the present invention, for the film produced to have variations in thickness, exposing "free" areas not covered by the sprayed liquid.

In the same way, the airflow for each spraying nozzle can be set independently to the type of technology, scale, premises where the process according to the present invention is worked. For example, the present invention is characterized in that the spraying of the solution or suspension of interacting objects is done with an airflow superior to 5 liters per minute per spray nozzle, preferably superior 10 liters per minute per spray nozzle, preferably superior to 30 liters per minute per spray nozzle, more preferably superior to 40 liters per minute per spray nozzle, or even superior to 50, 60, 70, 80, or 90 liters per minute per spray nozzle, depending of course of the type of nozzle envisaged. In a particular embodiment of the present invention applied to the industrial field, the airflow for each spraying nozzle can be superior to 100, 150 or 200 liters per minute per spray nozzle.

For example, the present invention is characterized in that the spraying of the solution or suspension of objects, preferably interacting objects, is done with a pressure equal or inferior to 5 bars, equal or inferior to 4 bars, equal or inferior to 3 bars, equal or inferior to 2 bars per spray nozzle. Moreover, the higher the airflow, the faster the thin layer of liquid produced will flow on the solid surface, thus enabling a higher degree of orientation of the anisotropic shaped objects.

It can thus easily be envisaged in the context of the present invention to add a supplementary gas nozzle to help push the liquid film across the solid surface, with airflows as disclosed above.

One of the aspects of the invention enables to also use any type of gas for the spraying process. According to one embodiment of the invention, the process is characterized in that the spraying of the solution or suspension of interacting objects is done with an inert or reactive gas, preferably chosen in the list consisting of nitrogen, argon, helium, oxygen, carbon dioxide, carbon monoxide, hydrogen, nitrous oxide, acetylene, ethylene, isobutene, methane, nitrogen monoxide, propane, silane, chlorine or a mixture thereof.

It is also possible that the chamber where the spraying is done is saturated in a particular an inert or reactive gas, preferably chosen in the list consisting of nitrogen, argon, helium, oxygen, carbon dioxide, carbon monoxide, hydrogen, nitrous oxide, acetylene, ethylene, isobutene, methane, nitrogen monoxide, propane, silane, chlorine or a mixture thereof.

By "reactive gas" it is meant in the context of the present invention gas which is known to be used for e.g. oxidation or reduction, basic or acidic reactions.

It is also possible to deposit films according to the present invention under a reduced pressure atmosphere by using ultrasound or electrospray nozzles.

It is also possible to deposit films according to the present invention under vacuum by using ultrasound or electrospray nozzles, for example.

One of the aspects of the present invention concerns the herein disclosed process characterized in that the concentration of the sprayed solution or suspension of interacting objects is below 10 wt%, preferably below 5 wt%, in order to enable spraying.

Preferably the concentration of the sprayed solution or suspension of interacting objects is below or equal to 1 wt%, below or equal to 0.5 wt% below or equal to 0.1 wt% below or equal to 0.05 wt% below or equal to 0.02 wt%, below or equal to 0.15 wt% below or equal to 0.125 wt%. The concentration should be smaller than the critical concentration for gel formation otherwise the viscosity is too high for spraying. As an example the critical concentration for gel formation of cellulose nanofibrils is about 2 %.

Preferably, the nature of the sprayed liquid (i.e. nature of the solvent, concentration of the various components, temperature, viscosity of the mixture, etc.) enables it to be sprayed conveniently. These properties and characteristics are easily controlled and chosen by the skilled person in the art according to his general technological background in a case-by-case way in order to achieve the present invention.

According to one embodiment of the invention, the process is characterized in that at least one complementary interacting chemical species, such as an interface and/or cohesion agent, preferably a polymer, is sprayed on the coated or uncoated substrate with an angle ranging between 70° to 90° in respect to the surface of said substrate, i.e. solid surface to be coated.

A complementary interacting chemical species layer, presented for example such as a polymer layer, which coats the substrate before the in-plane oriented layer is deposited thereon can be applied by dipping, spraying, doctor-blading, or any method known such as those to deposit a LbL-film. The choice of the deposition method for the complementary interacting chemical species layer has no measurable influence on the properties and orientation in the layer of oriented anisotropic objects as long as the complementary interacting chemical species layer is interacting with the in-plane oriented object thin layer. An important aspect is that the concentration of the complementary interacting chemical species in the complementary interacting chemical species layer which should be sufficiently high and the adsorption time for the complementary interacting chemical species layer sufficiently long as to permit regular LbL-build-up which is a technical term known to the skilled person in the art.

According to one embodiment of the invention, the process is characterized in that the complementary interacting chemical species is negatively charged or positively charged.

According to one embodiment of the invention, the process is characterized in that the interacting chemical species is negatively charged, preferably chosen from polyanionic polymers which can include, but is not limited to, a synthetic polymer, a biopolymer or modified biopolymer comprising carboxy, sulfo, sulfato, phosphono or phosphate groups or a mixture thereof, or a salt thereof. Examples of polyanionic polymers are: poly (acrylic acid) (PAA), poly (methacrylic acid) (PMA), poly(styrene sulfonate) (PSS), poly(lactic acid) (PLA), poly(lactic-*co*-glycolic acid) (PLGA), poly(glutamic acid) (PGA), poly maleic acid (PMA), sodium polyphosphate (PSP), poly(vinyl sulfate) (PVS), hyaluronic acid, carboxymethyl cellulose, carboxymethyl dextran, alginates, dextran sulfate carboxymethyl chitosans, sulfated or sulfonated polymers in general and the corresponding anionic copolymers.

According to one embodiment of the invention, the process is characterized in that the interacting chemical species is positively charged, preferably chosen from polycationic polymers which can include, but is not limited to a synthetic polymer, a biopolymer or modified biopolymer. Examples of polycationic polymers are: poly(ethylene imine) (PEI), Poly(allylamine hydrochloride) (PAH), poly(vinyl amine) (PVAm), poly(L-lysine) (*PLL*), poly(diallyldimethylammonium chloride) (*PDDA*), chitosan, poly(vinyl pyridine) (PVP) and the corresponding cationic copolymers.

According to one embodiment of the invention, the process is characterized in that the complementary interacting chemical species is an organic polymer or a mineral polymer.

According to one embodiment of the invention, the process is characterized in that the interacting chemical species is an organic polymer, preferably chosen from the lists above, e.g. poly(ethylene imine) (PEI), poly(acrylamide) (PAM), Poly(allylamine hydrochloride) (PAH), poly(vinylamine) (PVAm), poly(L-lysine) (*PLL*), poly(diallyldimethylammonium chloride) (*PDDA*), chitosanpolyacrylic acid (PAA), polymethacrylic acid (PMA), poly(styrenesulfonate) (PSS), poly(lactic acid) (PLA), poly(lactic-*co*-glycolic acid) (PLGA), poly(glutamic acid) (PGA), poly maleic acid (PMA), poly(methacrylic acid) (PMAA), poly(vinyl sulfate) (PVS), hyaluronic acid, carboxymethyl cellulose, carboxymethyl dextrans, alginates, carboxymethyl chitosans, or sulfated polysaccharides. By "organic polymer" is meant a polymer which comprises at least one CH, preferably CH-C, in the repeated monomer.

According to one embodiment of the invention, the process is characterized in that the interacting chemical species is a mineral polymer, preferably chosen from the lists above, e.g poly(phosphate) or to other well-known mineral polymers such as poly(siloxane) or aluminosilicates.

According to one embodiment of the invention, the process is characterized in that the sprayed suspension or dispersion is a suspension or dispersion in a liquid chosen from the list consisting of water (with a convenient purity of course e.g. MilliQ 18 M$\Omega$.cm), ethanol, methanol, propanol, pyridine, xylene, isopropanol, butanol, acetone, dimethyl formamide, dimethyl sulfoxide, acetonitrile, ethyl acetate, dicholoromethane, dichloroethane, diethylene glycol, chloroform, chlorobenzene, carbon tetrachloride, tetrahydrofuran, toluene, methyl pyrrolidinone, diethyl ether, cyclohexane, hexane, cyclopentane, and/or pentane. The solvents may contain a certain concentration (0-3 mol/L) of ions, including $Na^+$, $Cs^+$, $Li^+$, $K^+$, $NH_4^+$, $Be^{2+}$, $Mg^{2+}$, $Ca^{2+}$ $Mn^{2+}$, $Sr^{2+}$, $Ba^{2+}$, $Cl^-$, $Br^-$, $F^-$, $I^-$, $SO_4^{2-}$, $NO_3^-$, $PO_4^{3-}$.

According to one embodiment of the invention, the process is characterized in that the sprayed solution contains a solvent chosen in the list consisting of water (e.g. MilliQ 18 M$\Omega$.cm), ethanol, methanol, propanol, pyridine, xylene, isopropanol, butanol, acetone, dimethyl formamide, dimethyl sulfoxide, acetonitrile, ethyl acetate, dicholoromethane, dichloroethane, diethylene glycol, chloroform, chlorobenzene, carbon tetrachloride, tetrahydrofuran, toluene, methyl pyrrolidinone, diethyl ether, cyclohexane, hexane, cyclopentane, and/or pentane. The solvents may contain a certain concentration (0-3 mol/L) of ions, including $Na^+$, $Cs^+$, $Li^+$, $K^+$, $NH_4^+$, $Be^{2+}$, $Mg^{2+}$, $Ca^{2+}$ $Mn^{2+}$, $Sr^{2+}$, $Ba^{2+}$, $Cl^-$, $Br^-$, $F^-$, $I^-$, $SO_4^{2-}$, $NO_3^-$, $PO_4^{3-}$.

According to one embodiment of the invention, the process is characterized in that the temperature of the substrate, i.e. solid surface, and/or of the suspension or solution is below 40°C, preferably below 30°C, below 25°C, below 20°C, below 10°C and above 0°C or 10°C.

According to one embodiment of the invention, the process is characterized in that the solid surface, i.e. substrate or the surface of the substrate to be coated, is essentially made of quartz, organic polymers, silicon glass, metals, flexible plastic, silicium, metal oxides (as for example ITO), biological substrates.

Preferably the substrates are chosen in the list consisting of glass or organic polymer such as polycarbonates, acrylics, polyesters, polyvinyls, cellulose ester bases, polysulphones, polyimides, polycaprolactone.

Preferably the oxide substrate comprise at least one element selected from the group comprising of Al, Si, Ti, V, Cr, Mn, Fe, Co, Ni, Cu, Zn, Ga, Y, Zr, Nb, Mo, Ru, Rh, Cd, In, Sn, and Sb.

According to one embodiment of the invention, the process is characterized in that the spraying nozzle(s) are positioned at a distance from the solid surface, i.e.

substrate, to be coated comprised between 0.1 cm and 50 cm, preferably between 0.5 and 5 cm. According to one embodiment of the invention, the process is characterized in that the spraying according to step b) lasts less than 300 seconds, preferably less than 20 seconds.

According to one embodiment of the invention, the process is characterized in that a step f) is added wherein the coating is removed from the solid surface, i.e. substrate, preferably via the delamination of the coating or dissolution, melting or vaporization of said solid surface.

Another aspect of the present invention concerns a coating comprising one in-plane oriented layer of anisotropic shaped objects characterized in that the nematic order parameter of said coating is comprised between 0.5 and 1, preferably between 0.75 to 1, more preferably between 0.90 to 1, and even more preferably between 0.95 and 1, and optionally at least one complementary interacting chemical species such as an interface and/or cohesion agent.

In a preferred embodiment of the present invention, coating comprising one in-plane oriented layer of anisotropic shaped objects characterized in that the nematic order parameter of said coating is comprised between 0.6 and 1, between 0.7 and 1, between 0.8 and 1, between 0.85 and 1, between 0.90 and 0.99, between 0.91 and 0.98, between 0.92 and 0.97, between 0.93 and 0.96, between 0.94 and 0.95, and combinations thereof.

According to one embodiment of the invention, the coating is characterized in that it comprises at least one complementary interacting chemical species such as an interface and/or cohesion agent.

According to one embodiment of the invention, the coating is characterized in that it is multi-layered with a controlled sequence of layers of differently oriented or of different chemical species.

According to one embodiment of the invention, the coating is characterized in that the total number of layers is superior to 2, preferably superior to 20.

In one advantageous embodiment according to the present invention, the coating is characterized in that the total number of layers is equal or superior to 3, 4, 5, 6, 7, 8, 9, or 10.

In another advantageous embodiment according to the present invention, the coating is characterized in that the total number of layers is equal or superior to 30, 40, 50, 60, 70, 80, 90 or 100.

According to one embodiment of the invention, the coating is characterized in that the number of in-plane oriented layers of objects is superior to 1, preferably superior to 5. In one advantageous embodiment according to the present invention, the coating is characterized in that the number of in-plane oriented layers of objects is equal or superior to 3, 4, 5, 6, 7, 8, 9, or 10.

In another advantageous embodiment according to the present invention, the coating is characterized in that the number of in-plane oriented layers of objects is equal or superior to 30, 40, 50, 60, 70, 80, 90 or 100.

According to one embodiment of the invention, the coating is characterized in that the in-plane orientation angle, i.e. direction of each layer of oriented objects, shifts, i.e. rotates from one layer of oriented anisotropic objects to the next, with respect to the parallel plane defined by the solid surface, i.e. surface of substrate.

According to one embodiment of the invention, the coating is characterized in that the shifting angle, i.e. angular displacement from one layer of oriented anisotropic objects to the next, is constant from one layer to the next.

According to one embodiment of the invention, the coating is characterized in that the shifting angle, i.e. "angular displacement" or "angular shift" from one layer of oriented anisotropic objects to the next, is comprised from 0 to 180°, preferably from 0 to 90°. In the context of the present invention, the "shifting angle" (also called "angular shift") of the objects is the angular difference of the mean orientation per layer of the objects in the plane of the coating from one layer to the other. In particular, a shifting angle of 90 to 180° can be applied to asymmetrical objects, such as cone shaped objects.

Preferably, the shifting angle from one layer to the other can independently be below or equal to 90°, below or equal to 80°, below or equal to 70°, below or equal to 60°, below or equal to 50°, below or equal to 40°, below or equal to 30°, below or equal to 20°, below or equal to 10°, below or equal to 5°, below or equal to 2°, below or equal to 1°, or equal to 0° in what case there is no shifting angle.

Preferably in the particular case of asymmetrical objects, added to the particular shifting angles in orientations listed above, the shifting angle from one layer to the other can independently be below or equal to 180°, below or equal to 170°, below or equal to 160°, below or equal to 150°, below or equal to 140°, below or equal to 130°, below or equal to 120°, below or equal to 110°, below or equal to 100°.

According to one embodiment of the invention, the coating is characterized in that the superposed layers define a helicoid pattern with respect to the orientation of each oriented layer. To be more explicit, the shifting in orientation of objects from one layer to the next is continuously + or - in the whole of the coating or in a part of the coating. It is indeed possible to combine one or several helicoid patterns with other layers with random or organized orientations. Depending on the wanted effect, it is possible to vary the angle from one layer to the next in order to elongate the helix (i.e. decrease the angles from one layer to the next), or to shorten the helix (i.e. increase the angles from one layer to the next). It is also of course possible to obtain a regular helicoid pattern wherein the shifting of the orientation from one layer to the next is the same or substantially the same (i.e. more or less 5°). Typically, helicoid patterns can either be "left helixes" or "right helixes" as it is well known in the art. Televisions screens incorporating such multilayer oriented patterns could be of interest in order to obtain 3D luminous effects when viewing the screen.

The present invention enables the use of a device as presently disclosed to prepare a large surface coating, preferably superior to 1 cm$^2$, more preferably superior to 10cm$^2$, even more preferably superior to 50cm$^2$, yet more preferably superior to 1m$^2$ or even 10m$^2$.

Device according to the present invention, characterized in that at least one of the spray nozzles has an adjustable orthogonal tilting angle in respect to the surface, i.e. of the substrate, to be coated.

Device according to the present invention, characterized in that at least one spray nozzle or substrate to be coated comprises a translation movement back and forth along the parallel direction of the spraying.

The invention is further embodied in the following non-limiting examples and figures.

## FIGURES

Figure 1: SEM pictures of silver nanowires sprayed for 10 s (a), 20 s (b), 40 s (c) and 200 s (d), with the measured coverage as function of spraying time (respectively 15, 28, 41 and 61 %).

Figure 2: SEM pictures of silver nanowires sprayed on various substrates, with the distribution of nanowire angle with respect to the spraying direction and the corresponding nematic order parameter S. The substrates are a) glass coated with PEI, b) glass activated with a plasma treatment, c) silicon coated with PEI, d) PMMA coated with PEI, e) gold coated with PEI, f) aluminum coated with PEI and g) stainless steel coated with PEI.

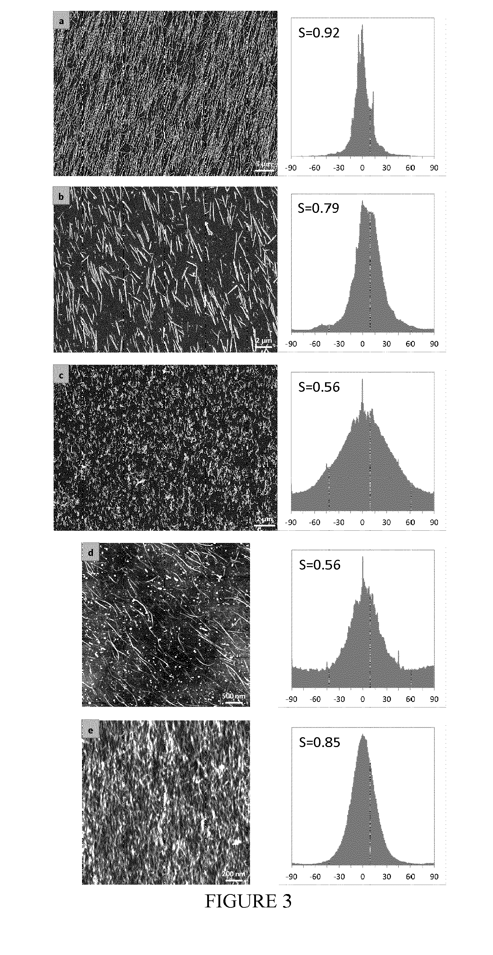

Figure 3: SEM (a, b and c) and AFM pictures (d and e) of a) silver nanowires, b) zinc oxide nanowires, c) gold nanorods, d) carbon nanotubes, and e) cellulose microfibrils sprayed on PEI coated glass substrates, with the corresponding angle distribution with respect to the spraying direction and the nematic order parameter.

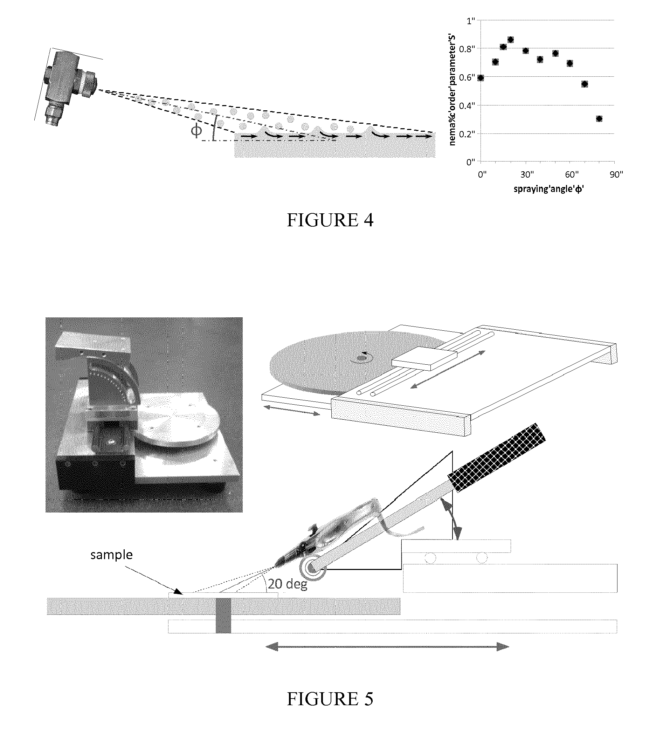

Figure 4: sketch of the nozzle and substrate, showing the spraying angle φ, and the nematic order parameter as function of the spraying angle for silver nanowires deposited on PEI-coated glass.

Figure 5: sketch and picture of the moveable linear guide device, which allows translational movement in the parallel and perpendicular directions with respect to the spraying direction. The substrate is placed on a holder which allows rotational movement in order to adjust the orientation between different layers.

Figure 6: map of the large area samples for both scanning velocities, with the nematic order parameter calculated from SEM pictures of aligned silver nanowires taken at various locations on the substrate.

Figure 7: SEM pictures (a, c: top view and b, d: cross-section) of multilayer samples (a, b: 5 nanowire layers oriented in the same direction and c, d: 5 nanowire layers each one oriented at 45° from the underlying layer orientation).

Figure 8: SEM pictures of perpendicularly oriented silver nanowires separated by a) 5 polyelectrolyte bilayers, b) 10 polyelectrolyte bilayers and c) 15 polyelectrolyte bilayers.

## EXAMPLES

### 1. <u>Spraying conditions</u>

The grazing incidence spraying of nanowires and nanorods has been performed with a Spraying Systems stainless steel nozzle (model B1/4J-SS). The nozzle is held at a distance of 1 cm from the substrate. Unless otherwise specified, the angle between the angle and the substrate plane is 20°. The nozzle is fed by compressed air (air flow 30 L/min) and the nanowire suspension is delivered by a HPLC pump (1 mL/min). The spraying time is 200 seconds, unless otherwise specified. Most experiments (unless otherwise specified) have been performed with a suspension of silver nanowires in Milli-Q water. The nanowire length and diameter are 4 ± 2 μm and 40 ± 5 nm respectively, and the nanowires are functionalized in situ during the synthesis by PVP (poly(vinyl pyrrolidone)). The suspension has been deposited on silicon oxide glass substrates unless otherwise specified. The substrates are coated with a PEI (poly(ethylene immine)) layer deposited by orthogonal spraying followed by a rinsing step with water. After deposition of the silver nanowires, the substrate is rinsed with water and dried using a gentle air flow.

### 2. <u>Characterization of the alignment</u>

The thin layers formed by grazing incidence spraying are imaged by Scanning Electron Microscopy (SEM). The nanowire angle distribution relative to the spraying direction θ is extracted from the SEM picture using an automated procedure based on the evaluation of the structure tensor in a local neighborhood (Biomech Model Mechanobiol 2012, 11, 461-473). The nematic order parameter S has been used to characterize the quality of alignment, where:

$$S = \langle \frac{3\cos^2\theta - 1}{2} \rangle$$

with $\theta$ being the angle between the nanowire long axis and the spraying direction. The nematic order parameter S is equal to 0 for a fully random nanowire orientation, whereas it is equal to 1 for a perfectly parallel set of nanowires.

### 3. Working embodiments

#### 3.1. mono layers of varying densities

The density of nanowires deposited on the surface can be tuned easily by varying the spraying time.

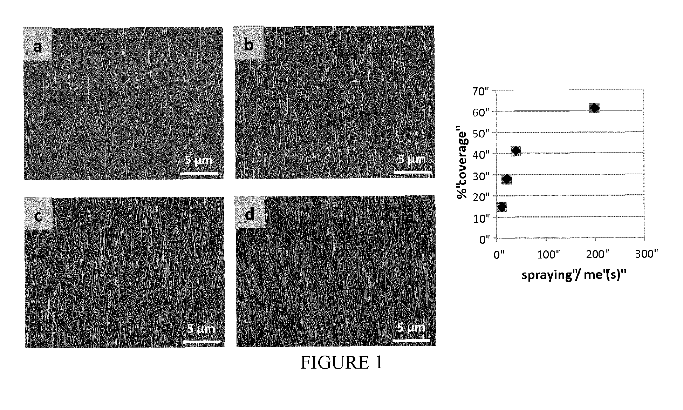

Different samples have been prepared by varying the deposition between 10 and 200 seconds (Figure 1). The coverage increases from 15% to 61% with the spraying time. A longer deposition time doesn't increase significantly the coverage.

#### 3.2. Deposition on various substrates

Silver nanowires have been deposited on various substrates, including silicon oxide glass, silicon, PMMA, gold, aluminum and steel.

The oriented deposition of silver nanowires is effective on a broad range of substrates, provided that there is a sufficient interaction between the nanowire and the substrate to be coated. Coating the substrate with a layer of PEI can provide this attractive interaction, but this is not mandatory, as exemplified by the successful deposition on bare glass activated by a plasma treatment. The nematic order parameter is almost substrate-independent for glass, silicon, gold and PMMA. The ordering is slightly reduced for the steel and aluminum substrates, probably due to the higher surface roughness which may modify the liquid flow at the liquid/substrate interface.

The detailed substrate preparation was as follows:

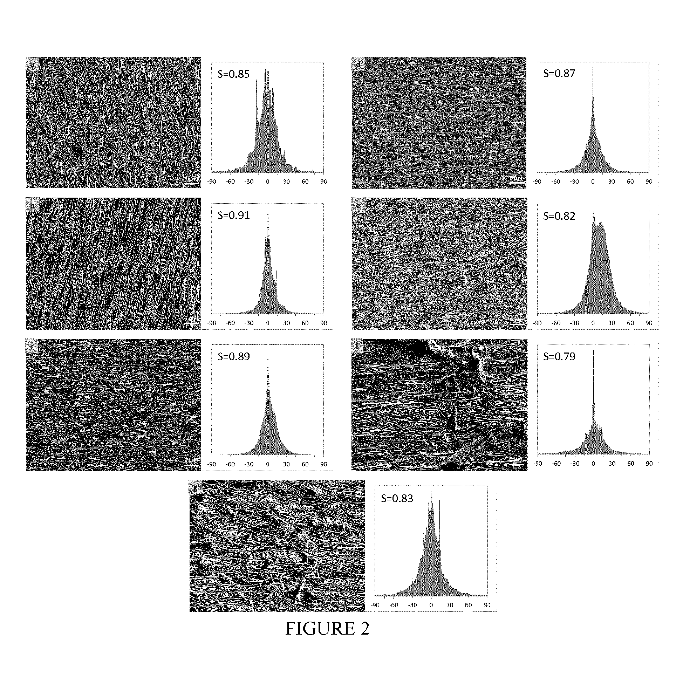

Figure 2a, c and d): the substrate (glass, silicon or PMMA) is successively soaked in ethanol in an ultrasound bath for 15 minutes, in MilliQ water in an ultrasound bath for 15 minutes, in a PEI solution in MilliQ water for 15 minutes, then rinsed in MilliQ water for 15 minutes, and finally dried with a gentle air stream.

Figure 2 b): the glass substrate is successively soaked in ethanol in an ultrasound bath for 15 minutes and in MilliQ water in an ultrasound bath for 15 minutes, followed by an exposure to plasma cleaner.

Figure 2 e): the gold surface (gold sputtered on a glass slide) is exposed to plasma cleaner, the successively soaked in a PEI solution in MilliQ water for 15 minutes and in MilliQ water for 15 minutes, and finally dried with a gentle air stream.

Figure 2f and g): the aluminum or steel substrates are mechanically polished, then successively soaked in acetone in an ultrasound bath for 30 minutes, in ethanol in an ultrasound bath for 30 minutes, in MilliQ water in an ultrasound bath for 15 minutes, in a PEI solution in MilliQ water for 15 minutes, then rinsed in MilliQ water for 15 minutes, and finally dried with a gentle air stream.

#### 3.3. Deposition of various anisotropic nanoparticles

In order to demonstrate the flexibility of the oriented deposition towards nanoparticle type, various anisotropic nanoparticles have been deposited on PEI-coated glass substrates. These particles show very different chemical nature and surface chemistries: metals, oxide, carbon-based material. It is not mandatory for the nanoparticle to be coated by a stabilizing molecule, provided that the particle itself has sufficient interaction with the PEI layer deposited on the substrate to ensure its adsorption.

Silver nanowires (coated with PVP) are 2-6 $\mu$m long and have a diameter of 40 nm (aspect ratio 50-150). Zinc oxide nanowires (uncoated) are 4-5 $\mu$m long and have a diameter of 300 nm (aspect ratio $\approx$ 15). Gold nanorods (coated with CTAB) are 100-400 nm long and have a diameter of 15 nm (aspect ratio $\approx$ 10-25). Carbon nanotubes (coated with PSS) are 1-5 $\mu$m long and have a diameter of 1.5 nm (aspect ratio $\approx$ 600). Cellulose microfibrils (uncoated) are 2-20 $\mu$m long and have a diameter of 1-50 nm (aspect ratio $\approx$ 30-500).

All samples show significant orientation. The variation in nematic order parameter could be ascribed to the aspect ratio variation, as low aspect ratio nano-objects (such as gold nanorods) are harder to orient compared to very elongated particles. The lower nematic order parameter for carbon nanotubes is due to artifacts in the image treatment induced the by the circular bright spots, which are due to impurities in the suspension, and which enlarges the angle distribution. The actual nematic order parameter is probably in the range 0.7-0.9. The density variation is due to the different affinities of the considered nanoparticle (or its coating) with the PEI coating applied on the glass substrate.

#### 3.4. Influence of the spraying angle

The spray angle and droplet velocity depend essentially on the liquid and gas flow rate as well as the distance and spray angle $\phi$ between the nozzle and the substrate. The nematic order parameter of aligned silver nanowires on PEI-coated glass substrates has been measured as function of the spraying angle $\phi$ between 0° and 80°. The nematic order parameter is higher than 0.5 for all angles below 70°, with a maximum around $\phi =$ 20°.

#### 3.5. Deposition on large areas

In order to coat large areas, a linear guide device which allows a translational movement of the nozzle above the substrate while keeping the spraying angle and nozzle to substrate distance constant.

Large PEI-coated silicon substrate (10 x 8 cm$^2$) have been used. The flow of liquid on the substrate is only present in front of the spraying nozzle, and thus a static liquid film stays on the surface after moving the spray nozzle to a different position. In order to reduce the adsorption of non-oriented nanowires from liquid which is not moving on the surface, an additional air flow has been added just next to the spraying nozzle in order to remove the remaining liquid once the nozzle is moved. Two different translational scanning velocities have been used perpendicularly to the spraying direction: 2 mm/s and 20 mm/s. The nozzle has not been moved in the parallel direction with respect to the spraying direction.

The use of the described device allows depositing nanowires on large areas with a significant orientation, although the nematic order parameter is below the one obtained without moving the nozzle with respect to the substrate. The quality of ordering is pretty homogeneous on the surface, being slightly reduced on the opposite side of the spray nozzle, possibly because the liquid flows with a lower velocity when the distance between nozzle and substrate increases.

3.6. Multilayers

Multilayer oriented nanoparticle assemblies can be made by combining the grazing incidence spraying with the well known Layer-by-Layer assembly technique. A complementary species has to be deposited on the nano-object layer, on top of which a subsequent layer of nano-objects can be deposited. It is also possible to adsorb polyelectrolyte layer pairs (alternating layers of positively and negatively charged polymers, sometimes also called bilayers) in order to tune the interlayer spacing. One advantage of the assembly technique is that the direction of alignment can be chosen independently in each oriented layer.

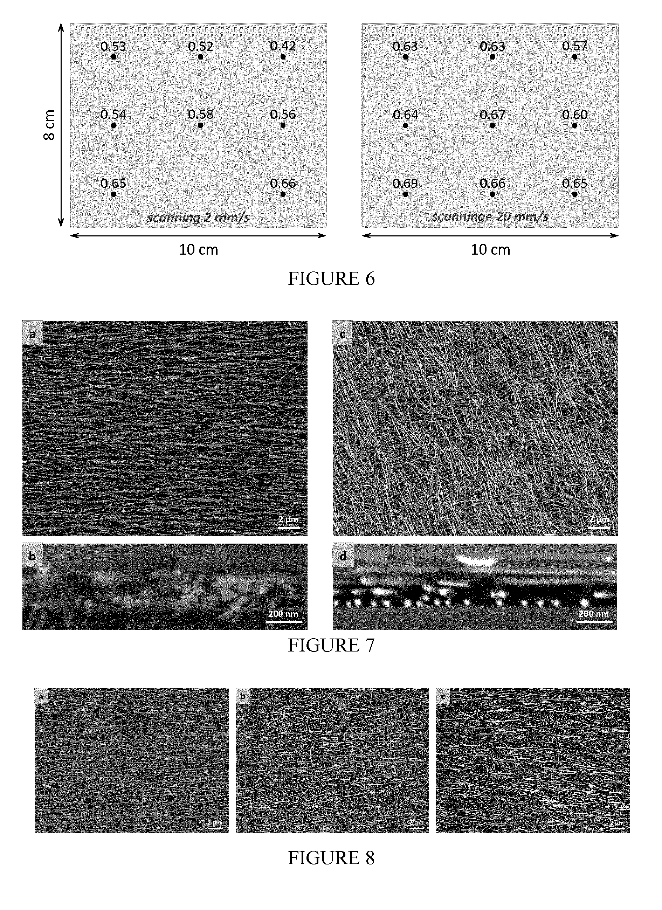

Figure 7 show SEM pictures of samples comprising 5 layers of silver nanowires separated by 6 layers of polyelectrolyte bilayers. The full structure of the thin film can be written as Si/PEI/Ag-NW/[PEI(PSS/PAH)$_5$PSS/PEI/AgNW]$_4$, where PEI is deposited in the layer beneath and above silver nanowires due to its strong affinity with the PVP-coated silver nanowires. 5 layer pairs of PSS/PAH are inserted between the silver nanowires to act as a spacer. Two examples are shown, in which the orientation is either the same in each silver nanowire layer (Figure 7a, b), either shifted by 45° between consecutive silver nanowire layers (Figure 7c, d).

Figure 8 shows 3 examples of 2 perpendicularly oriented layers of silver nanowires separated by different number of polyelectrolyte bilayers which act as spacers. The increased spacing between the nanowire layers can be distinguished by the apparent disappearance of the underlying layer when the total number of polyelectrolyte bilayers is increased. The full structure of the film can be described as Si/PEI/Ag-NW/PEI(PSS/PAH)$_n$PSS/PEI/AgNW, where n = 5, 10 and 15 for Figure 8 a, b and c respectively.

**Claims**

1. Process of preparation of a coated solid surface wherein the coating contains at least one in-plane oriented layer of anisotropic shaped objects, comprising:

   a) the preparation of at least one solution, suspension or dispersion of interacting objects,
   b) the spraying of at least one solution, suspension or dispersion of step a) on a solid surface said spraying is done with :

      - an angle inferior to 80°, preferably inferior to 30°, with respect to the plane formed by the solid surface to be coated,
      - a droplet speed superior to 0.1 meters per second,

   c) previously, simultaneously or subsequently to step b), an optional spraying or application of at least one complementary interacting chemical species, such as an interface and/or cohesion agent, onto the coated and/or uncoated surface,

      - steps a), b) and/or c) being reproduced as many times as necessary to obtain the desired coating, and

   d) retrieving the coated solid surface.

2. Process according to claim 1, **characterized in that** the solution, suspension or dispersion of step a) comprises at least one non-volatile solvent or non-volatile liquid vehicle.

3. Process according to claims 1or 2, **characterized in that** the objects are nano-objects preferably chosen in the list consisting of nanowires, nanorods, nanobelts, nanoribbons, nanorice, nanotubes, nanofibers, microfibrils, and/or microfibers.

4. Process according to any one of claims 1 to 3, **characterized in that** at least one complementary interacting chemical species, such as an interface and/or cohesion agent, preferably a polymer, is sprayed on the coated or uncoated solid surface with an angle ranging between 70° to 90° with respect to the solid surface to be coated.

5. Process according to any one of claims 1 to 4, **char-**

acterized in that the complementary interacting chemical species is negatively charged or positively charged.

6. Process according to any one of claims 1 to 5, **characterized in that** the complementary interacting chemical species is an organic polymer or a mineral polymer.

7. Process according to any one of claims 1 to 6, **characterized in that** a step f) is added wherein the coating is removed from the solid surface, preferably via the delamination of the coating or dissolution, melting or vaporization of said solid surface.

8. Process according to any one of claims 1 to 7, **characterized in that** a supplementary gas nozzle is added to push the liquid film across the solid surface.

9. Coating comprising at least one in-plane oriented layer of anisotropic shaped objects **characterized in that** the nematic order parameter of said coating is comprised between 0.5 and 1, preferably the coating comprises at least one complementary interacting chemical species.

10. Coating according to claim 9, **characterized in that** it is multi-layered with a controlled sequence of layers of differently oriented or of different chemical species.

11. Coating according to claims 9 or 10, **characterized in that** the in-plane orientation angle of each oriented layer of objects shifts from one layer to the next with respect to the parallel plane defined by the solid surface.

12. Coating according to claims 11, **characterized in that** the shifting angle is constant from one layer to the next.

13. Use of a coating according to any one of claims 9 to 12 for optical means, such as an optical polarizer, optical waveguide, a television screen, 3D screens, transparent conductive layer, chemical or biological detector, electro/magnetic means, such as an electronic device, in particular nanowire-based field effect transistor, conductivity controlled device, magnetic device, magnetoresistive device or an anisotropic device, or mechanical means such as a composite material with high Young's modulus, or oriented surfaces for biological cell culture.

14. Device for a spraying process in order to obtain a coating comprising at least one in-plane oriented layer of anisotropic shaped objects **characterized in that** said device comprises:

- at least one means of fixing a substrate to be coated on a support, said support being optionally arranged to allow the possibility of an angular orientation adjustment;
- at least one spray holder, comprising at least one spray nozzle mounted in a fixed or movable way through at least a translation movement back and forth along the orthogonal direction of the spraying.

15. Use of a device according to claim 14 to prepare a large surface coating, preferably superior to 1 cm$^2$.

FIGURE 1

FIGURE 2

FIGURE 3

FIGURE 4

FIGURE 5

FIGURE 6

FIGURE 7

FIGURE 8

Europäisches
Patentamt

European
Patent Office

Office européen
des brevets

## EUROPEAN SEARCH REPORT

Application Number

EP 14 30 5725

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2014/044865 A1 (HAICK HOSSAM [IL] ET AL) 13 February 2014 (2014-02-13) * paragraphs [0110], [0118], [0145], [0147], [0160], [0161], [0166], [0167], [0208] * | 1-3,9-15 | INV. B81C1/00 |
| A |  | 4-8 |  |

-----

TECHNICAL FIELDS
SEARCHED        (IPC)

B81C

The present search report has been drawn up for all claims

| Place of search | Date of completion of the search | Examiner |
|---|---|---|
| Berlin | 23 October 2014 | Foussier, Philippe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 14 30 5725

This annex lists the patent family members relating to the patent documents cited in the above-mentioned European search report.
The members are as contained in the European Patent Office EDP file on
The European Patent Office is in no way liable for these particulars which are merely given for the purpose of information.

23-10-2014

| Patent document cited in search report | Publication date | Patent family member(s) | Publication date |
|---|---|---|---|
| US 2014044865 A1 | 13-02-2014 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2008147431 A
- US 20140044865 A
- WO 9935520 A
- WO 2011144748 A
- WO 2011144754 A
- US 6451871 B

### Non-patent literature cited in the description

- **LIU, Q. ; CUI, Y. ; GARDNER, D. ; LI, X. ; HE, S. ; SMALYUKH, I. I.** Self-Alignment of Plasmonic Gold Nanorods in Reconfigurable Anisotropic Fluids for Tunable Bulk Metamaterial Applications. *Nano Lett.,* 2010, vol. 10, 1347-1353
- **ANDREA TAO et al.** Langmuir-Blodgett Silver Nanowire Monolayers for Molecular Sensing Using Surface-enhanced Raman Spectroscopy. *Nano Letters,* 2003, vol. 3 (9), 1229-1233
- **HONG-YAN SHI et al.** Ordering of Disordered Nanowires: Spontaneous Formation of highly Aligned, Ultralong Ag Nanowire Films at oil-water-air Interface. *Adv. Funct. Mater.,* 2010, vol. 20, 958-964
- **SHASHANK SHEKHAR et al.** Ultrahigh Density Alignment of Carbon Nanotube Arrays by Dielectrophoresis. *ACS Nano,* 2011, vol. 5 (3), 1739-1746
- **CARLOS M HANGARTER et al.** Hierarchical magnetic assembly of nanowires. *Nanotechnology,* 2007, vol. 18, 205305
- **ARNAUD DESSOMBZ et al.** Evidence for Photoconductivity Anisotropy in aligned TiO2 nanorod Films. *J. Phys. Chem. C.,* 2010, vol. 114, 19799-19802
- **WEN-ZE LI et al.** Stirring-assisted assembly of Nanowires at liquid-solid interfaces. *Nanotechnolgy,* 2013, vol. 24, 105302
- **YU HUANG et al.** Directed Assembly of One-dimensional Nanostructures into Functional Networks. *Science,* 2001, vol. 291, 630-633
- **LEE, S. G. ; KIM, H. ; CHOI, H. H. ; BONG, H.; ; PARK, Y. D. ; LEE, W. H. ; CHO, K.** Evaporation-Induced Self-Alignment and Transfer of Semiconductor Nanowires by Wrinkled Elastomeric Templates. *Adv. Mater.,* 2013, vol. 25, 2162-2166
- **PÉREZ-JUSTE, J. ; RODRÍGUEZ-GONZÁLEZ, B. ; MULVANEY, P. ; LIZ-MARZÁN, L. M.** Optical Control and Patterning of Gold-Nanorod-Poly(vinyl alcohol) Nanocomposite Films. *Adv. Funct. Mater.,* 2005, vol. 15, 1065-1071
- **OSSAMA ASSAD et al.** Spray coating Route for highly Aligned and Large-Scale Arrays of Nanowires. *ACS Nano,* 2012, vol. 6 (6), 4702-4712
- **LU, A.-H. ; SALABAS, E. L. ; SCHÜTH, F.** Magnetic Nanoparticles: Synthesis, Protection, Functionalization, and Application. *Angew. Chem. Int. Ed.,* 2007, vol. 46, 1222-1244
- **DANIEL, M.-C. ; ASTRUC, D.** Gold Nanoparticles: Assembly, Supramolecular Chemistry, Quantum-Size-Related Properties, and Applications toward Biology. *Catalysis, and Nanotechnology. Chem. Rev.,* 2003, vol. 104, 293-346
- **SCHLENOFF J. B. ; DUBAS S. T. ; FARHAT T.** Sprayed polyelectrolyte multilayers. *Langmuir,* 2000, vol. 16, 9968-9969
- *Biomech Model Mechanobiol,* 2012, vol. 11, 461-473